# EUROPEAN PATENT SPECIFICATION

(11) **EP 3 813 502 B1**
(45) Date of publication and mention of the grant of the patent: **12.08.2026**
(21) Application number: 18923615.1
(22) Date of filing: 20.06.2018
(51) Int. Cl.: H05K 13/04, H05K 13/00, H05K 13/08

(54) **CONTROL METHOD, ELECTRONIC COMPONENT MOUNTING DEVICE, AND CORRECTION SUBSTRATE**
STEUERVERFAHREN, MONTAGEVORRICHTUNG FÜR ELEKTRONISCHE KOMPONENTE UND KORREKTURSUBSTRAT
PROCÉDÉ DE COMMANDE, DISPOSITIF DE MONTAGE DE COMPOSANT ÉLECTRONIQUE ET SUBSTRAT DE CORRECTION

(43) Date of publication of application: 28.04.2021
(73) Proprietor: Fuji Corporation, Chiryu-shi, Aichi 472-8686 (JP)
(72) Inventor: KONDO, Daigo, Chiryu-shi, Aichi 472-8686 (JP)
(74) Representative: Grünecker Patent- und Rechtsanwälte PartG mbB
(86) International application number: PCT/JP2018/023401
(87) International publication number: WO 2019/244264

(56) References cited:
- JP-A- 2001 136 000
- JP-A- 2001 244 696
- JP-A- 2001 516 503
- JP-A- 2012 038 834
- JP-A- 2017 157 765
- JP-A- H01 227 499
- JP-A- H11 274 799

## Description

### Technical Field

The present invention relates to a control method, an electronic component mounting device, and a correction substrate.

### Background Art

Conventionally, there has been a technique for improving mounting accuracy in a device for mounting an electronic component on a substrate (for example, Patent Literature 1). As one example, there is a technique for correcting the movement amount of a mounting head in a manner such that an imaging section provided with the mounting head images marks of the correction substrate one by one on which multiple marks are arranged in advance. Specifically, this is performed by detecting a deviation amount between a position of the mark imaged after moving the mounting head a predetermined distance and a position of the mark based on the assumption of moving the mounting head the predetermined distance, and reflecting the deviation amount to a mounting work of the electronic component.

JP 2017 157765 relates to calibrating a mounting apparatus using marks in a homogeneous lattice pattern of marks with equal spacing between the marks in x-direction and in y-direction. The lattice pattern is scanned by taking images of the marks along each column (in x-direction), and the errors are used to correct the displacement at each coordinate point.

### Patent Literature

Patent Literature 1: JP-A-2001-136000

### Summary of the Invention

### Technical Problem

In the above-described correction method, by narrowing the pitch of the marks arranged on the correction substrate, it is possible to improve the accuracy of the correction. However, when the pitch of the marks is narrowed, there was a problem that the number of marks increased, which turns out increasing the inspection time.

The present application has been proposed in view of the above-described problems, and an object thereof is to provide a technique capable of improving correction accuracy while suppressing an increase in inspection time.

The invention is defined by the features of the independent claims. Any reference to inventions or embodiments not falling within the scope of the independent claims are to be interpreted as examples useful for understanding the invention.

### Solution to Problem

According to an aspect of the present description, there is provided a control method of an electronic component mounting device in accordance with claim 1.

According to another aspect of the present description, there is provided an electronic component mounting device in accordance with claim 3.

Furthermore, in an aspect not being part of the claimed invention, there is provided a correction substrate for correcting a movement distance of a moving device in an electronic component mounting device including a mounting head, the moving device that moves the mounting head, and an imaging section that is disposed on the mounting head and images the correction substrate on which marks are arranged, the correction substrate including: a first mark column in which the marks are arranged at a predetermined pitch in a first direction; and a second mark column which is provided at a position apart from the first mark column in a second direction by a predetermined distance, and in which the marks, of which positions in the first direction are different from the positions of the marks included in the first mark column in the first direction, are arranged at a predetermined pitch in the first direction.

### Advantageous Effect of the Invention

According to the present disclosure, it is possible to provide a technique capable of improving the correction accuracy while suppressing the increase in inspection time.

### Brief Description of Drawings

Fig. 1 is a perspective view of an electronic component mounting device according to an embodiment.
Fig. 2 is a plan view of the electronic component mounting device.
Fig. 3 is a block diagram illustrating a control system of the electronic component mounting device.
Fig. 4 is a view illustrating a correction substrate.
Fig. 5 is a view illustrating an arrangement form of conventional marks.
Fig. 6 is a view for describing a detection position and an error.
Fig. 7 is a graph of the error.
Fig. 8 is a view for describing a linear complement.
Fig. 9 is a view illustrating an arrangement form of marks in the embodiment.
Fig. 10 is a view for describing a correction method in the embodiment, Fig. 10(a) illustrates an error in which an Y address is 1, Fig. 10(b) illustrates an error in which an Y address is 2, and Fig. 10(c) illustrates an error used for correction.
Fig. 11 is a view illustrating an arrangement form of marks according to a first another example.
Fig. 12 is a view illustrating an arrangement form of marks according to a second another example.
Fig. 13 is a view illustrating an arrangement form of marks according to a third another example.

### Description of Embodiments

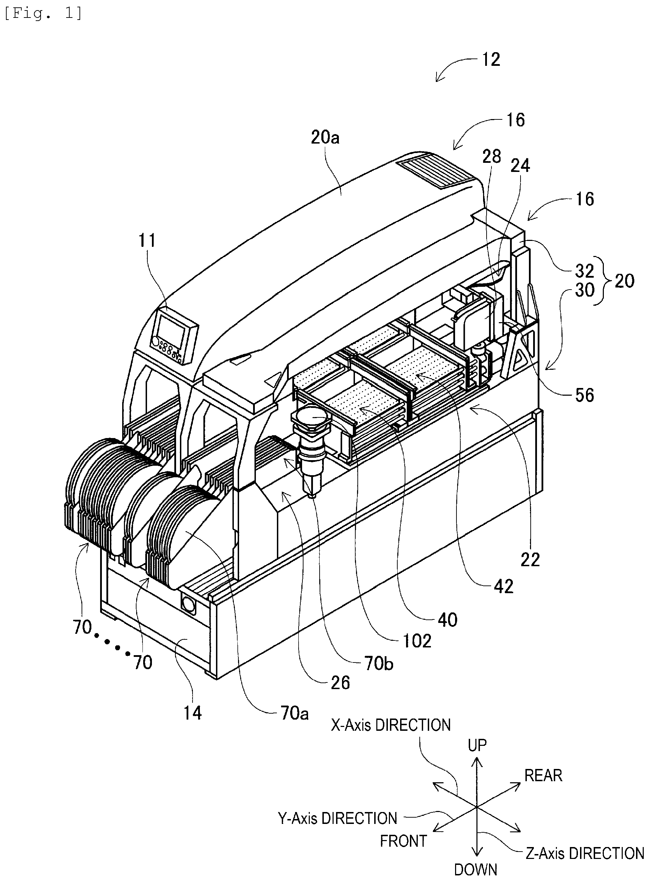

As illustrated in Fig. 1, electronic component mounting device 12 (hereinafter, abbreviated as mounting device) includes system base 14 and two mounters 16. Two mounters 16 are installed adjacent to each other on system base 14. Mounter 16 includes mounter main body 20, conveyance device 22, mounting head moving device 24 (hereinafter, abbreviated as moving device), supply device 26, mounting head 28, upper cover 20a, part camera 102, and touch panel 11. Mounting device 12 mounts electronic components on a substrate such as a printed circuit substrate, for example, which is conveyed by conveyance device 22 to perform the work of mounting. **In** the following description, the direction illustrated in Fig. 1 is used. A direction in which the substrate is conveyed by conveyance device 22 is referred to as an X-axis direction, and a direction orthogonal to the X-axis direction is referred to as a Y-axis direction.

Mounter main body 20 includes frame section 30 and beam section 32 provided to extend over frame section 30. Upper cover 20a is disposed above beam section 32. Touch panel 11 is disposed above the front side of mounter 16, displays the operation information of mounter 16, and receives an instruction from an operator or the like. Part camera 102 is disposed between conveyance device 22 and supply device 26 and images an electronic component held by mounting head 28.

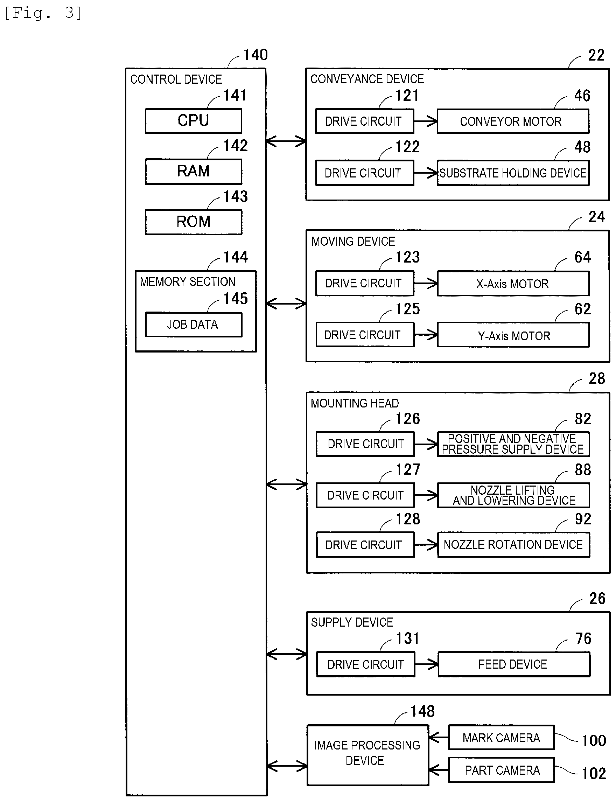

Conveyance device 22 includes two conveyor devices 40 and 42 and substrate holding device 48 (Fig. 3). Two conveyor devices 40 and 42 extend in the X-axis direction and are disposed parallel to each other on frame section 30. Using conveyor motor 46 (Fig. 3) as a driving source, each of two conveyor devices 40 and 42 conveys the substrate supported by each of conveyor devices 40 and 42 in the X-axis direction. Substrate holding device 48 pushes up to fix the conveyed substrate at a predetermined position.

Supply device 26 is a feeder-type supply device and is disposed at the end portion on the front side of frame section 30. Supply device 26 includes multiple tape feeders 70. Tape feeder 70 includes supply reel 70a and feed device 76 (Fig. 3). Taped electronic components are wound on supply reel 70a. While unwinding the tape wound around supply reel 70a, feed device 76 unseals the tape to feed out the electronic components to component supply section 70b provided at a rear end of tape feeder 70.

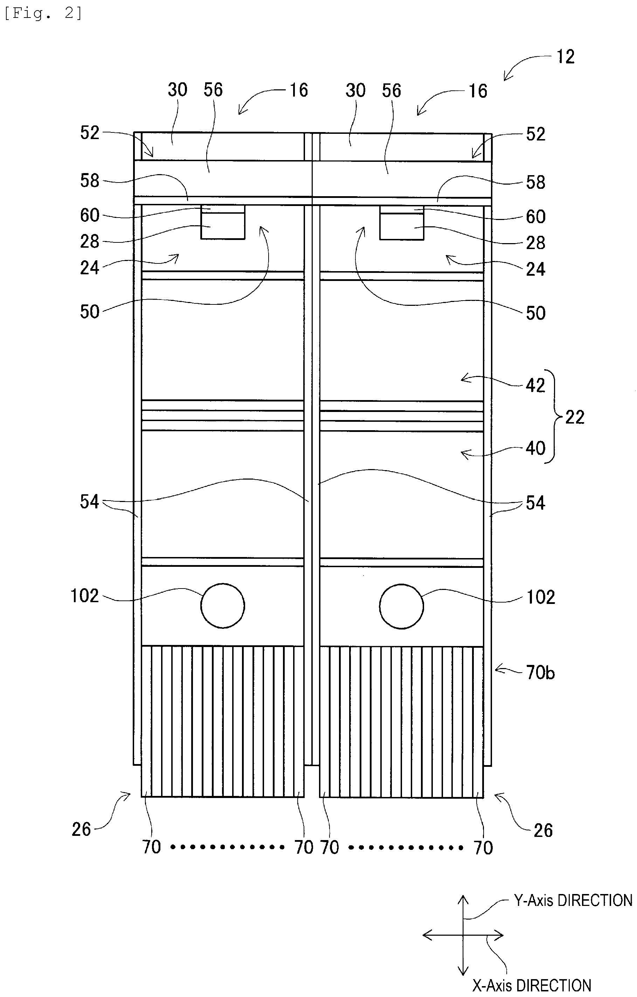

Referring to Fig. 2, moving device 24 will be described. Furthermore, Fig. 2 is a plan view illustrating mounting device 12 in a state where upper cover 20a is removed from the viewpoint from above. Moving device 24 includes Y-axis direction slide mechanism 52 and X-axis direction slide mechanism 50 and the like. Y-axis direction slide mechanism 52 includes a pair of Y-axis direction guide rails 54 extending in the Y-axis direction, Y-axis slider 56, Y-axis motor 62 (Fig. 3), and the like. Y-axis slider 56 is guided by Y-axis direction guide rail 54 in accordance with the driving of Y-axis motor to move to any position in the Y-axis direction. X-axis direction slide mechanism 50 includes X-axis direction guide rail 58 extending in the X-axis direction, X-axis direction guide rail 58, and X-axis slider 60. X-axis direction guide rail 58 is fixed to Y-axis slider 56 and X-axis slider 60 is guided by X-axis direction guide rail 58 in accordance with the driving of X-axis motor 64 (Fig. 3) to move to any position in the X-axis direction. Mounting head 28 which picks up and mounts the electronic component on the substrate is fixed to X-axis slider 60.

Mounting head 28 includes suction nozzle (not illustrated), positive and negative pressure supply device 82 (Fig. 3), nozzle lifting and lowering device 88 (Fig. 3), nozzle rotation device 92 (Fig. 3), and mark camera 100 (Fig. 3) and the like. The suction nozzle is attached to the lower surface of mounting head 28. Further, mounting head 28 has a supply path for supplying negative pressure air from positive pressure air from positive and negative pressure supply device 82. With this configuration, mounting head 28 can pick up and hold an electronic component by being supplied with negative pressure air, and mounting head 28 can release the held electronic component by being supplied with slightly positive pressure air. Nozzle lifting and lowering device 88 raises and lowers the suction nozzle, and nozzle rotation device 92 rotates the suction nozzle about an axis. With this configuration, the suction nozzle can change the position in the up-down direction and the holding orientation of the held electronic component.

Next, the mounting work of mounter 16 will be described. The substrate is conveyed to a predetermined position by conveyor devices 40 and 42 and is fixed by substrate holding device 48. On the other hand, moving device 24 moves mounting head 28 to supply device 26. Next, the suction nozzle is lowered to the position of the electronic component supplied by supply device 26, and picks up and holds the electronic component. Thereafter, the suction nozzle rises. Moving device 24 then moves mounting head 28 above the mounting position of the substrate. Next, the suction nozzle is lowered to the substrate position and releases the electronic component. In this manner, mounting head 28 mounts the electronic components on the substrate.

With reference to Fig. 3, a description will be given of the configuration of the control system of the mounter 16. In addition to the above-described configuration, mounter 16 includes control device 140, image processing device 148, mark camera 100, and the like. Control device 140 includes CPU 141, RAM 142, ROM 143, memory section 144, and the like. CPU 141 controls electrically connected sections by executing various programs stored in ROM 143. Here, these sections include conveyance device 22, moving device 24, mounting head 28, supply device 26, image processing device 148, and the like. RAM 142 is used as a main storage device when CPU 141 executes various processes. Control programs and various pieces of data are stored in ROM 143. Memory section 144 is realized by, for example, a flash memory, and job data 145, various types of information, and the like are recorded in memory section 144.

In addition to the above-described configurations, conveyance device 22 includes drive circuit 121 for driving conveyor motor 46, drive circuit 122 for driving substrate holding device 48, and the like. In addition to the above-described configurations, moving device 24 includes drive circuit 123 for driving X-axis motor 64, drive circuit 125 for driving Y-axis motor 62, and the like.

In addition to the above-described configurations, mounting head 28 includes drive circuit 126 for driving positive and negative pressure supply device 82, drive circuit 127 for driving nozzle lifting and lowering device 88, drive circuit 128 for driving nozzle rotation device 92, and the like.

In addition to the above-described configurations, supply device 26 includes drive circuit 131 for driving feed device 76 and the like. Mark camera 100 is fixed to the lower surface of X-axis slider 60 in a state of facing downward, and for example, images a reference mark or the like for substrate positioning, which is formed on the substrate. Image processing device 148 is realized by, for example, a computer, and mark camera 100 and part camera 102 perform image processing with respect to the captured image data. More specifically, the position of the outer shape of, for example, an electronic component included in the image data is digitized, and the digitized data is output to CPU 141.

Control device 140 controls moving device 24 such that mounting head 28 is positioned at a mounting position on the substrate in accordance with job data 145. Moving device 24 drives X-axis motor 64 and Y-axis motor 62 so as to achieve each movement amount in the X-axis direction and the Y-axis direction. However, an error occurs between the driving amount of X-axis motor 64 and Y-axis motor 62, and the actual movement amount. Therefore, before performing the mounting work, this error is measured, and by correcting the driving amount based on the measured error, the accuracy of the mounting position on the substrate is improved. The correction method will be described.

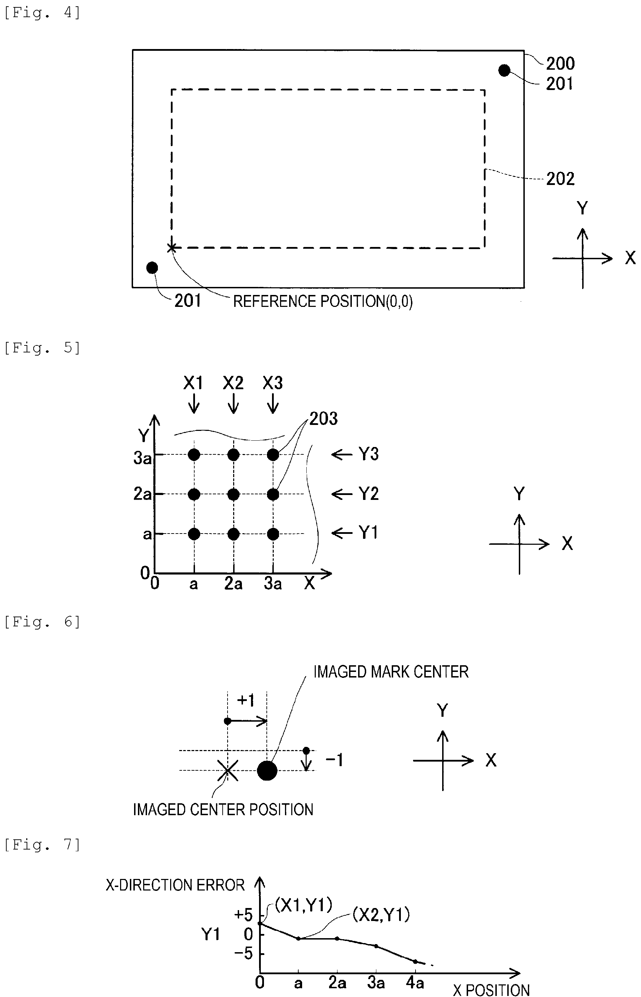

For the correction, correction substrate 200 illustrated in Fig. 4 is used. Correction substrate 200 is a rectangular glass substrate. Inspection F marks 201 and 201 are formed at each of a pair of diagonal angles of correction substrate 200. Inspection F mark 201 has, for example, a circular shape. Arranged marks 203 (Fig. 5) are formed in mark region 202 of correction substrate 200. First, an arrangement form of marks 203 in conventional mark region 202 and a correction method will be described. Furthermore, in the following description of correction substrate 200, using the direction illustrated in Fig. 4, the rightward direction on a paper surface, which is the longitudinal direction of correction substrate 200, is the X-direction, and the upward direction is the Y-direction.

Conventionally, as illustrated in Fig. 5, marks 203 are arranged in a matrix in mark region 202. Furthermore, the shape of mark 203 is, for example, circular, may have the same shape and size as those of inspection F mark 201, and may have different shapes and sizes. Here, it is assumed that marks 203 are arranged at pitch a in the X-direction and the Y-direction. An address is given to mark 203, and with the reference position of mark region 202 illustrated in Fig. 4 as the origin, it is assumed that Y1, Y2, Y3, and ... are given in the Y-direction to the marks aligned in the X-direction, and X1, X2, X3, and ... are given in the X-direction to the marks aligned in the Y-direction. In the following description, there is a case where addresses are described using coordinate notation. For example, there is a case where mark 203, of which the address in the X-direction is X1 and the address in the Y-direction is Y1, is described as mark 203 at the address (X1, Y1).

In the measurement of the error, first, the position of correction substrate 200 is specified by inspection F mark 201. Next, by mark camera 100, one mark 203 is imaged, and the position of imaged mark 203 is specified. Specifically, control device 140 calculates the position of mark 203 at the address (X1, Y1) based on the position of specified inspection F marks 201 and 201. Next, control device 140 controls moving device 24 such that the position of calculated mark 203 coincides with the center position of the imaging field of mark camera 100. Next, by causing mark camera 100 to perform imaging, control device 140 calculates the error between the center position of the imaging field of mark camera 100 and the center position of mark 203 based on the captured image. When describing using schematically drawn Fig. 6, in a case where the center position of mark 203 is deviated by -1 in the X-direction and by +1 in the Y-direction with respect to the center position of the imaging field of mark camera 100, the error of mark 203 at the address (X1, Y1) is calculated to be -1 in the X-direction and to be +1 in the Y-direction. After imaging mark 203 at the address (X1, Y1), mark camera 100 is moved by pitch a in the X-direction, and imaging of mark 203 at the address (X2, Y1) and calculation of the error are performed in the same manner as mark 203 at the address (X1, Y1). Subsequently, when the movement and imaging of mark camera 100 in the X-direction and the calculation of the error are performed, and the imaging of mark 203 at the address Y1 and the calculation of the error are completed, then the imaging of mark 203 at the address Y2 and the calculation of the error are performed. In this manner, the movement by pitch a in the X-direction and the movement by pitch a in the Y-direction are repeated, and the imaging of all marks 203 arranged in mark region 202 and the calculation of the error are performed.

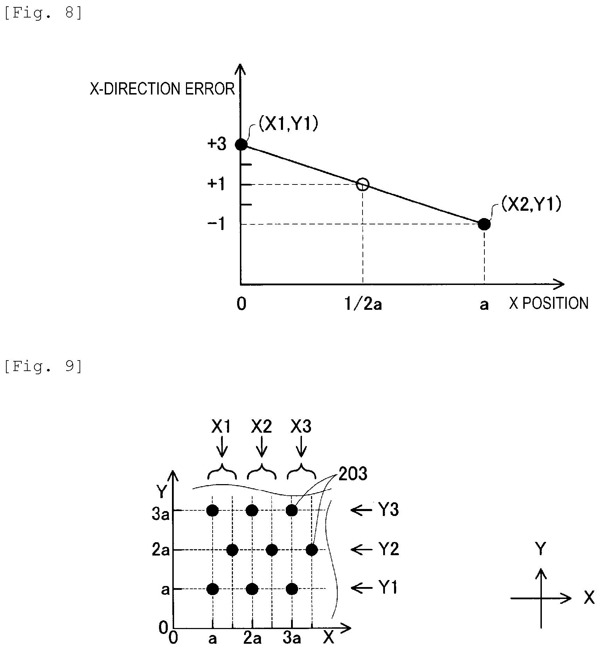

With respect to mark 203 at the address Y1, the result of the calculated error in the X-direction is graphed as illustrated in Fig. 7. In Fig. 7, the horizontal axis indicates the position of mark 203 in the X-direction with the reference position of mark region 202 as the origin, and the vertical axis indicates the calculated error in the X-direction. Control device 140 corrects the movement amount in the mounting work based on the calculated error. Here, the minimum unit of the mounting position of the electronic component on the substrate is finer than pitch a. Therefore, control device 140 performs linear complement for the section where the measurement is not performed. For example, as illustrated in Fig. 8, in a case where the X-direction error of mark 203 at the address (X1, Y1) is +3 and the X-direction error of mark 203 at the address (X2, Y1) is -1, the error of the position separated from mark 203 at the address (X1, Y1) by 1/2a in the X-direction is set to +1. In this manner, since the interpolated value is used for the section where the measurement is not performed, in order to improve the mounting accuracy, it is considered to more finely measure the arrangement pitch of marks 203. However, when the arrangement pitch is made fine, the number of measurement points increases, and therefore, there is a problem that the inspection time becomes long. Therefore, in the embodiment, marks 203 are arranged as illustrated in Fig. 9.

In the embodiment, the positions of marks 203 in the X-direction are arranged in mark region 202 so as to be deviated by 1/2a for each row. Specifically, marks 203 having an even number of Y addresses are deviated by 1/2a in the X-direction with respect to marks 203 having an odd number of Y addresses. In marks 203 arranged in this manner, similarly to the conventional art, marks 203 are imaged one by one, and the error is calculated. Next, a detailed description will be given.

For example, when the start of the correction process is instructed by the user, control device 140 executes the following correction process in accordance with the control program stored in memory section 144. First, control device 140 specifies the position of correction substrate 200 with inspection F mark 201. Next, control device 140 calculates the position of mark 203 at the address (X1, Y1) based on the positions of the specified inspection F marks 201 and 201. Next, moving device 24 is controlled to make the position of mark 203 at the address (X1, Y1) coincide with the center position of the imaging field of mark camera 100, then the mark camera 100 is caused to image mark 203, so that the detection position of mark 203 at the address (X1, Y1) is specified based on the captured image. Specifically, the coordinates of mark 203 are calculated in a case where the center position of the imaging field of mark camera 100 is (0, 0). After imaging mark 203 at the address (X1, Y1), the movement of mark camera 100 in the X-direction and the imaging are sequentially performed. Furthermore, with respect to one row of marks 203 of which the address is Y1, the process of performing imaging by mark camera 100 and specifying the detection position is an example of a first specifying step and a first specifying process.

When the imaging of mark 203 at the address Y1 is completed, control device 140 controls moving device 24 to make the position of mark 203 at the address (X1, Y2) coincide with the center position of the imaging field of mark camera 100, then causes mark camera 100 to image mark 203, and specifies the detection position of mark 203 at the address (X2, Y1) based on the captured image. Specifically, the coordinates of mark 203 are calculated in a case where the center position of the imaging field of mark camera 100 is (0, 0). After imaging mark 203 at the address (X2, Y1), the movement of mark camera 100 in the X-direction and the imaging are sequentially performed. Furthermore, with respect to one row of marks 203 of which the address is Y2, the process of performing imaging by mark camera 100 and specifying the detection position is an example of a second specifying step and a second specifying process.

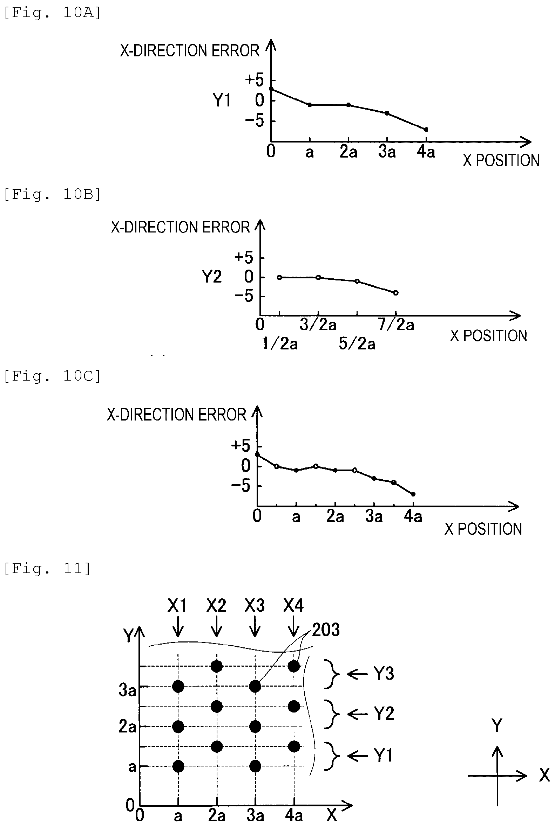

Thereafter, control device 140 similarly specifies the detection positions for all marks 203. Thereafter, based on the specified detection position, an error is calculated (an example of the first calculating step and the first calculating process). The error here is a difference between the set movement distance and the actual movement distance that mounting head 28 is moved by moving device 24 so as to move by a set distance. Furthermore, since the detection position is the coordinate with the center position of the imaging field of mark camera 100 is (0, 0), the X-coordinate of the detection position becomes an error in the X-direction, and the Y-coordinate of the detection position becomes an error in the Y-direction. Next, the correction of the movement amount is performed by calculating (an example of a second calculating step and a second calculating process) the correction value based on the calculated error. A correction method of the movement amount will be described with reference to Fig. 10.

In Figs. 10(a) and 10(b), similar to Fig. 7, the horizontal axis indicates the position of mark 203 in the X-direction with the reference position of mark region 202 as the origin, and the vertical axis indicates the calculated error in the X-direction. Fig. 10(a) illustrates the result of one row of marks 203 of which the address is Y1, and Fig. 10(b) illustrates the result of one row of marks 203 of which the address is Y2. In a case of performing correction of the section of mark region 202 corresponding to the address Y2 from the address Y1, control device 140 uses the result of mark 203 of which the address is Y1 and mark 203 of which the address is Y2. When describing using the graph, similar to Fig. 10(c), the error of one row of marks 203 of which the address is Y1 and the error of one row of marks 203 of which the address is Y2 are combined and aligned in accordance with the position in the X-direction. Regarding the region corresponding to the addresses Y1 to Y2, that is, the region in which the position of Y is a to 1/2a, the movement amount is corrected based on the result of the error. Specifically, for example, the correction value is calculated by dividing the actual movement distance by the set movement distance, and the value obtained by dividing the driving amount that corresponds to the set movement distance by the correction value is considered as the driving amount to be used in the mounting work. Here, the actual movement distance is, for example, a value obtained by adding an error to pitch a.

As the process performed by control device 140, the error of one row of marks 203 of which the address of Y is n and the error of one row of marks 203 of which the address of Y is (n+1) are combined and aligned in accordance with the address of X. Next, the correction value of the region is calculated based on the error of mark 203 of which the address of X is n and the error of mark 203 of which the address of X is (n+1). As described above, for example, the correction value here is a value indicated as a ratio of the actual movement distance with respect to pitch a. Furthermore, in this manner, the reason why the error of one row of marks 203 of which the address of Y is n and the error of one row of marks 203 of which the address of Y is (n+1) are treated equally is that the tendency of the error in mark 203 in the vicinity is approximated. Control device 140 performs the correction in the Y-direction in the same manner as the correction in the X-direction. In other words, the error of mark 203 in one column in which the X position is (n × a) and the error of mark 203 in one column in which the X position is (n × a + 1/2a) are combined and aligned according to the addresses of Y. Next, based on the error of mark 203 in which the X position is (n × a) and the error of mark 203 in which the X position is (n × a + 1/2a), the correction value of the region is calculated. When control device 140 completes the calculation of the correction value with respect to all marks 203, and completes the correction process. Thereafter, by using the movement distance of moving device 24 which is corrected based on the correction value calculated by the correction process, the mounting work is performed (an example of a mounting work step and a mounting work process). In other words, based on the correction value, the driving amounts of X-axis motor 64 and Y-axis motor 62 are corrected, and the mounting work is performed.

In the above-described embodiment, control device 140 is an example of a control section, mark camera 100 is an example of an imaging section, X-direction is an example of a first direction, and Y-direction is an example of a second direction. The row of marks 203 having an odd number of Y addresses, in which marks 203 are arranged at pitch a in the X-direction, is an example of a first mark column, and the row of marks 203 having an even number of Y addresses is an example of a second mark column. In marks 203 having an odd number of Y addresses, pitch a is an example of a predetermined pitch.

According to the first embodiment described above, the following effects are obtained. Correction substrate 200 includes a row of marks 203 having an odd number of Y addresses and a row of marks 203 having an even number of Y addresses, in which marks 203 are arranged at pitch a in the X-direction. Marks 203 having an odd number of Y addresses and marks 203 having an even number of Y addresses are different in position in the X-direction. Control device 140 calculates the error by moving moving device 24, by imaging marks 203 one by one by mark camera 100, and by specifying the detection position of each mark 203. Based on the error of mark 203 having n Y addresses and the error of mark 203 having (n + 1) Y addresses in the vicinity, the correction value is calculated, and the mounting work is performed using the movement distance of moving device 24, which is corrected based on the correction value. Based not only on the error of mark 203 having n Y addresses but also on the error of mark 203 having (n + 1) Y addresses, it is possible to further improve accuracy of the correction value than that of the calculation of the correction value based only on the error of mark 203 having n Y addresses. It is possible to actually further narrow the pitch of the detection position that when only the error of mark 203 having n Y addresses is used, and thus, it is possible to improve the accuracy of the correction value. When calculating the correction value in the Y-direction, based on mark 203 in the vicinity in the X-direction, the correction value is calculated, and the mounting work is performed using the movement distance of moving device 24, which is corrected based on the correction value. Based not only one column of marks 203 having the same X position but also on the error of one column of marks 203 which is at a position separated by 1/2a in the X-direction, it is possible to maintain the accuracy of the correction value in the Y-direction. Therefore, as compared with the conventional correction substrate (Fig. 5) arranged in a matrix at pitch a in the X-direction and Y-direction, since there is no case where the number of marks 203 increases, it is possible to improve the correction accuracy in the X-direction while suppressing the increase in inspection time.

Further, on correction substrate 200, the row of marks 203 of which the X position is (n × a), and the row of marks 203 of which the X position is (n × a + 1/2a) are adjacent to each other. Accordingly, since it is possible to use the error of mark 203 of which the position in the Y-direction is close, it is possible to improve the accuracy of the correction. Therefore, by making the row of marks 203 of which the X position is (n x a) and the row of marks 203 of which the X position is (n × a + 1/2a) adjacent to each other, it is possible to improve the accuracy of the correction.

On correction substrate 200, the interval between the positions of marks 203 having an odd number of Y addresses and marks 203 having an even number of Y addresses in the X-direction is equal. Specifically, marks 203 having an odd number of Y addresses and marks 203 having an even number of Y addresses are disposed separated from each other by 1/2a in the X-direction. Accordingly, the correction in the X-direction can be performed uniformly.

### Another Example

Next, another example of the arrangement form of marks 203 on correction substrate 200 will be described. In the description above, as illustrated in Fig. 9, an example in which one row of marks 203 aligned at pitch a in the X-direction and one adjacent row of marks 203 aligned at pitch a in the X-direction are different in position in the X-direction, has been described. Unlike this, as illustrated in Fig. 11, an arrangement form in which one column of marks 203 aligned at pitch a in the Y-direction, and one adjacent column of marks 203 aligned at pitch a in the Y-direction are different in position in the Y-direction, may be employed.

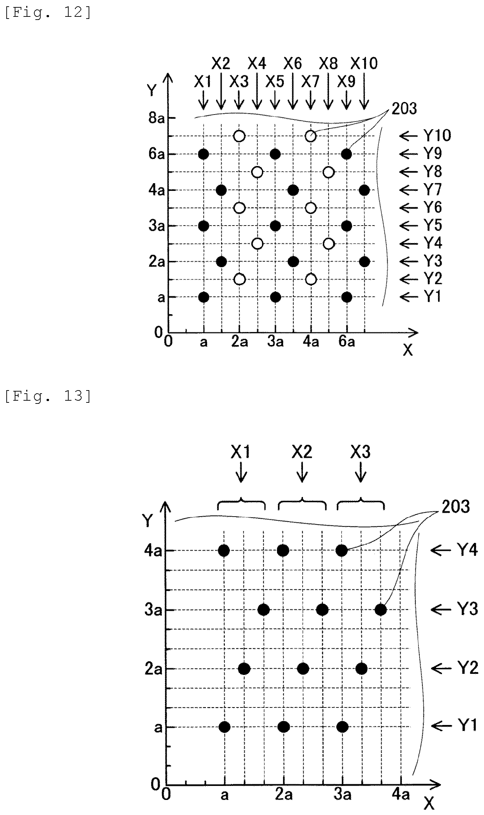

The arrangement form may be as illustrated in Fig. 12. The example illustrated in Fig. 12 is an arrangement form in which two adjacent columns of marks 203 illustrated in Fig. 9 are considered as one set, and one set of the target columns is deviated by 1/2a in the Y-direction with respect to one adjacent set of columns. In Fig. 12, one set of columns is displayed in white or black. According to correction substrate 200 of the arrangement form, in any of the X-direction and the Y-direction, it is also possible to improve the accuracy of the correction value. For example, when performing correction in the X-direction, for the target row, by using the error of two rows separated by 1/2a in the Y-direction and the error of one row separated by a in the Y-direction, it is possible to perform correction using the error of unit of 1/2a. When performing correction in the Y-direction, similarly, for the target column, by using the error of two columns separated by 1/2a in the X-direction and the error of one column separated by a in the X-direction, it is possible to perform correction using the error of unit of 1/2a.

In the description above, as illustrated in Fig. 9, the arrangement form in which the position of mark 203 at the address Y1 in the X-direction and the position of mark 203 at the address Y2 in the X-direction are deviated by 1/2a, which is half of pitch a, has been described. The deviation amount is not limited to half pitch a. For example, as illustrated in Fig. 13, the arrangement form in which the deviation amount is 1/3a may also be employed.

An example in which the first mark column and the second mark column are adjacent to each other is not limited to the above. For example, the first mark column, the first mark column, the second mark column, and the second mark column may be arranged in this order in the second direction.

Further, in the description above, in the correction process, moving device 24 is controlled to make the position of mark 203 coincides with the center position of the imaging field of mark camera 100, then move mounting head 28 so as to cause mark camera 100 to perform imaging. The present invention is not limited to the configuration of imaging after movement, and a configuration of performing imaging during the movement of mounting head 28 may be employed.

### Reference Signs List

12 electronic component mounting device, 28 mounting head, 100 mark camera, 140 control device, 141 CPU, 203 mark, 200 correction substrate

## Claims

1. A control method of an electronic component mounting device (12) including a mounting head (28), a moving device (24) that moves the mounting head (28), and an imaging section that is disposed on the mounting head (28) and images a correction substrate (200) on which marks (203) are arranged,
wherein the correction substrate (200) includes:
a first mark column in which the marks (203) are arranged at a predetermined pitch in a first direction, and
a second mark column, being provided at a position apart from the first mark column in a second direction by a predetermined distance, in which the marks (203), of which positions in the first direction are different from the positions of the marks (203) included in the first mark column in the first direction, are arranged at a predetermined pitch in the first direction, wherein the first mark column and the second mark column are adjacent to each other on the correction substrate (200),
the method comprising:
specifying the position of the correction substrate (200) and calculating the position of the marks (203),
a first specifying step of specifying a detection position of the marks (203) by moving the mounting head (28) to the calculated position of the marks (203) included in the first mark column such that the position of the calculated marks (203) coincides with the center position of the imaging field, and imaging the marks (203) by the imaging section;
a second specifying step of specifying the detection position of the marks (203) by moving the mounting head (28) to the calculated position of the marks (203) included in the second mark column such that the position of the calculated marks (203) coincides with the center position of the imaging field, and imaging the marks (203) by the imaging section;
a first calculating step of calculating errors of the detection positions by calculating the error between the center position of the imaging field and the center position of marks (203) based on the captured image;
a second calculating step of calculating a correction value when moving the moving device (24), the calculation being performed based on the calculated errors in the first mark column and the calculated errors in the second mark column in the vicinity of the first mark column; and
a mounting work step of causing the mounting head (28) to execute mounting work of an electronic component on a substrate using a movement distance of the moving device (24), which is corrected based on the correction value.

2. The control method according to claim 1, wherein
an interval between the positions of the marks (203) included in the first mark column and the marks (203) included in the second mark column in the first direction is equal.

3. An electronic component mounting device (12) comprising:
a mounting head (28);
a moving device (24) configured to move the mounting head (28);
an imaging section configured to be disposed on the mounting head (28) and image
a correction substrate (200) on which marks (203) are arranged; and
a control section, wherein
the correction substrate (200) includes a first mark column in which the marks (203) are arranged at a predetermined pitch in a first direction, and
a second mark column, being provided at a position apart from the first mark column in a second direction by a predetermined distance, in which the marks (203), of which positions in the first direction are different from the positions of the marks (203) included in the first mark column in the first direction, are arranged at a predetermined pitch in the first direction wherein the first mark column and the second mark column are adjacent to each other on the correction substrate (200), and
the control section is configured to specify the position of correction substrate (200) and calculating the position of marks (203) and to execute a first specifying process of specifying a detection position of the marks (203) by moving the mounting head (28) to the calculated position of the marks (203) included in the first mark column such that the position of the calculated marks (203) coincides with the center position of the imaging field, and imaging the marks (203) by the imaging section,
a second specifying process of specifying the detection position of the marks (203) by moving the mounting head (28) to the position of the marks (203) included in the second mark column such that the position of the calculated marks (203) coincides with the center position of the imaging field, and imaging the marks (203) by the imaging section,
a first calculating process of calculating errors of the detection positions by calculating the error between the center position of the imaging field and the center position of marks (203) based on the captured image,
a second calculating process of calculating a correction value when moving the moving device (24) based on the calculated errors in the first mark column and the calculated errors in the second mark column in the vicinity of the first mark column, and
a mounting work process of causing the mounting head (28) to execute mounting work of the electronic component on the substrate using a movement distance of the moving device (24), which is corrected based on the correction value.

## Patentansprüche

1. Steuerungsverfahren für eine Vorrichtung (12) zum Montieren elektronischer Bauteile, die einen Montagekopf (28), eine Bewegungsvorrichtung (24), die den Montagekopf (28) bewegt, sowie einen Bilderzeugungsabschnitt aufweist, der an dem Montagekopf (28) angeordnet ist und ein Bild eines Korrektur-Substrats (200) erzeugt, an die Markierungen (203) angeordnet sind,
wobei das Korrektur-Substrat (200) einschließt:
eine erste Markierungs-Spalte, in der die Markierungen (203) in einem vorgegebenen Abstand in einer ersten Richtung angeordnet sind, sowie
eine zweite Markierungs-Spalte, die sich an einer Position befindet, die von der ersten Markierungs-Spalte um eine vorgegebene Entfernung in einer zweiten Richtung getrennt ist, wobei die Markierungen (203), deren Positionen in der ersten Richtung sich von den Positionen der in der ersten Markierungs-Spalte enthaltenen Markierungen (203) in der ersten Richtung unterscheiden, in einem vorgegebenen Abstand in der ersten Richtung angeordnet sind, wobei die erste Markierungs-Spalte und die zweite Markierungs-Spalte auf dem Korrektur-Substrat (200) benachbart zueinander sind,
wobei das Verfahren umfasst:
Bestimmen der Position des Korrektur-Substrats (200) und Berechnen der Position der Markierungen (203),
einen ersten Bestimmungs-Schritt, in dem eine Erfassungsposition der Markierungen (203) bestimmt wird, indem der Montagekopf (28) so an die berechnete Position der in der ersten Markierungs-Spalte enthaltenen Markierungen (203) bewegt wird, dass die Position der berechneten Markierungen (203) mit der Mittelposition des Bilderzeugungs-Feldes zusammenfällt, und Bilder der Markierungen (203) mit dem Bilderzeugungsabschnitt erzeugt werden;
einen zweiten Bestimmungs-Schritt, in dem die Erfassungsposition der Markierungen (203) bestimmt wird, indem der Montagekopf (28) so an die berechnete Position der in der zweiten Markierungs-Spalte enthaltenen Markierungen (203) bewegt wird, dass die Position der berechneten Markierungen (203) mit der Mittelposition des Bilderzeugungs-Feldes zusammenfällt, und Bilder der Markierungen (203) mit dem Bilderzeugungsabschnitt erzeugt werden;
einen ersten Berechnungs-Schritt, in dem Abweichungen der Erfassungspositionen berechnet werden, indem die Abweichung zwischen der Mittelposition des Bilderzeugungs-Feldes und der Mittelposition von Markierungen (203) auf Basis des aufgenommenen Bildes berechnet wird;
einen zweiten Berechnungs-Schritt, in dem ein Korrekturwert beim Bewegen der Bewegungsvorrichtung (24) berechnet wird, wobei die Berechnung auf Basis der berechneten Abweichungen in der ersten Markierungs-Spalte sowie der berechneten Abweichungen in der zweiten Markierungs-Spalte in der Nähe der ersten Markierungs-Spalte durchgeführt wird; und
einen Montagearbeits-Schritt, in dem der Montagekopf (28) veranlasst wird, Arbeit zum Montieren eines elektronischen Bauteils auf einem Substrat unter Verwendung einer Bewegungsstrecke der Bewegungsvorrichtung (24) auszuführen, die auf Basis des Korrekturwertes korrigiert wird.

2. Steuerungsverfahren nach Anspruch 1, wobei
ein Zwischenraum zwischen den Positionen der in der ersten Markierungs-Spalte enthaltenen Markierungen (203) und den in der zweiten Markierungs-Spalte enthaltenen Markierungen (203) in der ersten Richtung gleich ist.

3. Vorrichtung (12) zum Montieren elektronischer Bauteile, die umfasst:
einen Montagekopf (28);
eine-Bewegungsvorrichtung (24), die zum Bewegen des Montagekopfes (28) ausgeführt ist;
einen Bilderzeugungsabschnitt, der so ausgeführt ist, dass er an dem Montagekopf (28) angeordnet ist, und ein Bild eines Korrektur-Substrats (200) erzeugt, an dem Markierungen (203) angeordnet sind; sowie
einen Steuerungsabschnitt, wobei
das Korrektur-Substrat (200) eine erste Markierungs-Spalte, in der die Markierungen (203) in einem vorgegebenen Abstand in einer ersten Richtung angeordnet sind, sowie eine zweite Markierungs-Spalte einschließt, die sich an einer Position befindet, die von der ersten Markierungs-Spalte in einer zweiten Richtung um eine vorgegebene Entfernung getrennt ist, in der die Markierungen (203), deren Positionen in der ersten Richtung sich von den Positionen der in der ersten Markierungs-Spalte enthaltenen Markierungen (203) in der ersten Richtung unterscheiden, in einem vorgegebenen Abstand in der ersten Richtung angeordnet sind, wobei die erste Markierungs-Spalte und die zweite Markierungs-Spalte auf dem Korrektur-Substrat (200) aneinandergrenzen, und der Steuerungsabschnitt so ausgeführt ist, dass er die Position des Korrektur-Substrats (200) bestimmt und die Position von Markierungen (203) berechnet und ausführt:
einen ersten Bestimmungsprozess zum Bestimmen einer Erfassungsposition der Markierungen (203), indem er den Montagekopf (28) so an die berechnete Position der in der ersten Markierungs-Spalte enthaltenen Markierungen (203) bewegt, dass die Position der berechneten Markierungen (203) mit der Mittelposition des Bilderzeugungs-Feldes zusammenfällt, und Erzeugen von Bildern der Markierungen (203) mit dem Bilderzeugungsabschnitt,
einen zweiten Bestimmungsprozess zum Bestimmen der Erfassungsposition der Markierungen (203), indem er den Montagekopf (28) so an die Position der in der zweiten Markierungs-Spalte enthaltenen Markierungen (203) bewegt, dass die Position der berechneten Markierungen (203) mit der Mittelposition des Bilderzeugungs-Feldes zusammenfällt, und Erzeugen von Bildern der Markierungen (203) mit dem Bilderzeugungsabschnitt;
einen ersten Berechnungsprozess, in dem Abweichungen der Erfassungspositionen berechnet werden, indem die Abweichung zwischen der Mittelposition des Bilderzeugungs-Feldes und der Mittelposition von Markierungen (203) auf Basis des aufgenommenen Bildes berechnet wird;
einen zweiten Berechnungsprozess, in dem ein Korrekturwert beim Bewegen der Bewegungsvorrichtung (24) auf Basis der berechneten Abweichungen in der ersten Markierungs-Spalte sowie der berechneten Abweichungen in der zweiten Markierungs-Spalte in der Nähe der ersten Markierungs-Spalte berechnet wird, und
einen Montagearbeits-Prozess, in dem der Montagekopf (28) veranlasst wird, Arbeit zum Montieren des elektronischen Bauteils auf dem Substrat unter Verwendung einer Bewegungsstrecke der Bewegungsvorrichtung (24) auszuführen, die auf Basis des Korrekturwertes korrigiert wird.

## Revendications

1. Procédé de commande d'un dispositif de montage de composants électroniques (12) comportant une tête de montage (28), un dispositif de déplacement (24) qui déplace la tête de montage (28), et une partie d'imagerie qui est disposée sur la tête de montage (28) et produit une image d'un substrat de correction (200) sur lequel sont disposés des repères (203),
dans lequel le substrat de correction (200) comporte :
une première colonne de repères dans laquelle les repères (203) sont disposés suivant un intervalle prédéfini dans une première direction, et
une seconde colonne de repères, située au niveau d'une position distante de la première colonne de repères suivant une distance prédéfinie dans une seconde direction, dans lequel les repères (203), dont les positions dans la première direction sont différentes des positions des repères (203) compris dans la première colonne de repères dans la première direction, sont disposés suivant un intervalle prédéfini dans la première direction, dans lequel la première colonne de repères et la seconde colonne de repères sont adjacentes l'une à l'autre sur le substrat de correction (200),
le procédé comprenant :
la spécification de la position du substrat de correction (200) et le calcul de la position des repères (203),
une première étape de spécification consistant à spécifier une position de détection des repères (203) par déplacement de la tête de montage (28) jusqu'à la position calculée des repères (203) compris dans la première colonne de repères de telle sorte que la position des repères (203) calculés coïncide avec la position centrale du champ d'imagerie, et à produire une image des repères (203) à l'aide de la partie d'imagerie ;
une seconde étape de spécification consistant à spécifier la position de détection des repères (203) par déplacement de la tête de montage (28) jusqu'à la position calculée des repères (203) compris dans la seconde colonne de repères de telle sorte que la position des repères (203) calculés coïncide avec la position centrale du champ d'imagerie, et à produire une image des repères (203) à l'aide de la partie d'imagerie ;
une première étape de calcul consistant à calculer des erreurs des positions de détection par calcul de l'erreur entre la position centrale du champ d'imagerie et la position centrale des repères (203) sur la base de l'image capturée ;
une seconde étape de calcul consistant à calculer une valeur de correction lors du déplacement du dispositif de déplacement (24), le calcul étant effectué sur la base des erreurs calculées dans la première colonne de repères et des erreurs calculées dans la seconde colonne de repères au voisinage de la première colonne de repères ; et
une étape de travail de montage consistant à amener la tête de montage (28) à exécuter un travail de montage d'un composant électronique sur un substrat en utilisant une distance de déplacement du dispositif de déplacement (24) corrigée sur la base de la valeur de correction.

2. Procédé de commande selon la revendication 1, dans lequel
un intervalle entre les positions des repères (203) compris dans la première colonne de repères et des repères (203) compris dans la seconde colonne de repères dans la première direction est identique.

3. Dispositif de montage de composants électroniques (12) comprenant :
une tête de montage (28) ;
un dispositif de déplacement (24) conçu pour déplacer la tête de montage (28) ;
une partie d'imagerie conçue pour être disposée sur la tête de montage (28) et produire des images d'un substrat de correction (200) sur lequel sont disposés des repères (203) ; et
une partie de commande, dans lequel
le substrat de correction (200) comporte une première colonne de repères dans laquelle les repères (203) sont disposés suivant un intervalle prédéfini dans une première direction, et
une seconde colonne de repères, située au niveau d'une position distante d'une distance prédéfinie de la première colonne de repères dans une seconde direction, dans lequel les repères (203), dont les positions dans la première direction sont différentes des positions des repères (203) compris dans la première colonne de repères dans la première direction, sont disposés suivant un intervalle prédéfini dans la première direction, dans lequel la première colonne de repères et la seconde colonne de repères sont adjacentes l'une à l'autre sur le substrat de correction (200), et
la partie de commande est configurée pour spécifier la position du substrat de correction (200) et calculer la position de repères (203) et pour exécuter une première opération de spécification consistant à spécifier une position de détection des repères (203) par déplacement de la tête de montage (28) jusqu'à la position calculée des repères (203) compris dans la première colonne de repères de telle sorte que la position des repères (203) calculés coïncide avec la position centrale du champ d'imagerie, et à produire une image des repères (203) à l'aide de la partie d'imagerie,
une seconde opération de spécification consistant à spécifier la position de détection des repères (203) par déplacement de la tête de montage (28) jusqu'à la position des repères (203) compris dans la seconde colonne de repères de telle sorte que la position des repères (203) calculés coïncide avec la position centrale du champ d'imagerie, et à produire une image des repères (203) à l'aide de la partie d'imagerie,
une première opération de calcul consistant à calculer des erreurs des positions de détection par calcul de l'erreur entre la position centrale du champ d'imagerie et la position centrale des repères (203) sur la base de l'image capturée,
une seconde opération de calcul consistant à calculer une valeur de correction lors du déplacement du dispositif de déplacement (24) sur la base des erreurs calculées dans la première colonne de repères et des erreurs calculées dans la seconde colonne de repères au voisinage de la première colonne de repères, et
une opération de travail de montage consistant à amener la tête de montage (28) à exécuter un travail de montage du composant électronique sur le substrat en utilisant une distance de déplacement du dispositif de déplacement (24), qui est corrigée sur la base de la valeur de correction.
